# EUROPÄISCHE PATENTSCHRIFT

(11) **EP 0 898 343 B1**
(45) Veröffentlichungstag und Bekanntmachung des Hinweises auf die Patenterteilung: **05.04.2006**
(21) Anmeldenummer: 98112955.4
(22) Anmeldetag: 13.07.1998
(51) Int. Cl.: H01R 43/20, H05K 13/04

(54) **Einpresswerkzeug zum Einpressen elektrischer Anschlussbauteile in Leiterplatten**
Tool for inserting electric terminals in printed circuit boards
Outil d'insertion des éléments de contact électriques dans des circuits imprimés

(30) Priorität: 18.08.1997 DE 29714747 U
(43) Veröffentlichungstag der Anmeldung: 24.02.1999
(73) Patentinhaber: Weidmüller Interface GmbH & Co., 32760 Detmold (DE)
(72) Erfinder: Beege, Werner, 63512 Hainburg (DE); Radde, Werner, 64832 Babenhausen (DE); Müller, Beatrice, 63322 Rödermark (DE)
(74) Vertreter: Stracke, Alexander

(56) Entgegenhaltungen:
- DE-U- 8 622 117
- US-A- 4 328 613
- US-A- 4 793 816

## Beschreibung

Die Erfindung betrifft ein Einpreßwerkzeug zum Einpressen von elektrischen Anschlußbauteilen in Leiterplatten. Bislang sind einteilige Einpreßwerkzeuge handelsüblich, die mit dem Hubmechanismus einer kleinen Presse oder einer sonstigen Hubeinrichtung zu verbinden sind und die dann beim Einpressen auf die nach oben weisende Gehäusefläche der Anschlußbauteile gepreßt werden, um die Einpreßkräfte zu übertragen. Diese Vorgehensweise ist für verschiedene elektrische Anschlußbauteile problematisch, insbesondere bei Stiftleisten, deren einzupressende Stifte um 90° abgewinkelt liegen. In einem solchen Fall können sich die Einpreßkräfte besonders ungünstig auf die Bauteile auswirken. Einpreßkräfte können zu Bauteilverformungen führen. Um dem abzuhelfen, werden gesonderte Einlegeteile genommen und zu Abstützungszwecken der kritischen Stellen in die Anschlußbauteile eingesetzt, die dann nach der Montage für den Einpreßvorgang auch wieder demontiert werden müssen. Der gleichen Problematik unterliegen alle elektrischen Anschlußbauteile, bei denen die Einpreßkräfte nicht zentrisch auf den einzupressenden Stift übertragen werden können.

Ein mehrteiliges Einpresswerkzeug ist aus DE 86 22 117.3 bekannt.

Der vorliegenden Erfindung liegt von daher die Aufgabe zugrunde, ein Einpreßwerkzeug zu schaffen, das den umständlichen Einsatz von gesonderten Einlegeteilen auch bei den genannten problembehafteten elektrischen Anschlußbauteilen vermeidet und dabei eine Gefahr der Verformung der Anschlußbauteile vermieden wird.

Die erfindungsgemäße Lösung ergibt sich aus dem kennzeichnenden Teil des Anspruches 1. Die Mehrteiligkeit des Einpreßwerkzeuges mit einem auf das Gehäuse des Anschlußbauteiles aufsetzbaren Druckteil, einem ein Bewegungsspiel gegenüber dem Druckteil aufweisenden Hubteil und einem von dem Hubteil zu betätigenden drehbaren Abstützteil mit Abstützelementen ermöglicht es, mittels des verschiebbaren Hubteiles zunächst das drehbare Abstützteil mit den Abstützelementen in das Anschlußbauteil einzuschwenken und damit alle kritischen Zonen abzustützen, bevor das Hubteil das Druckteil erreicht und mit Hilfe des Druckteiles die Einpreßkräfte auf das Gehäuse des Anschlußbauteiles aufbringt. Damit ist gewährleistet, daß zwangsläufig bei jedem Einpreßvorgang eine sichere Abstützung der kritischen Stellen der problembehafteten Anschlußbauteile erfolgt, bevor die Einpreßkräfte aufgebracht werden. Ein derartiges Einpreßwerkzeug stellt dabei sicher, daß sich das Einpressen von problematischen elektrischen Anschlußbauteilen automatisieren läßt, ohne daß die Gefahr von Verformungen der Bauteile besteht.

Zu Beginn der Abhebebewegung des Einpreßwerkzeuges ist das drehbare Abstützteil mit den Abstützelementen aus dem eingepreßten Anschlußbauteil herauszuschwenken. Dies kann in Art einer kraftschlüssigen Bewegungskopplung in denkbar einfacher Weise beispielsweise dadurch geschehen, daß zwischen dem Druckteil und dem daran gelagerten Abstützteil eine Feder angeordnet ist, deren Federkraft auf die Herausschwenkung des Anschlußteiles gerichtet ist. Die Kraft der Feder wird dabei bei der Einschwenkung des Abstützteiles durch das Hubteil überwunden. Weitere bevorzugte Ausgestaltungen, die insbesondere auch den einfachen konstruktiven Aufbau eines derartigen Einpreßwerkzeuges betreffen, sind in Unteransprüchen gekennzeichnet.

Ein bevorzugtes Ausführungsbeispiel eines erfindungsgemäßen Einpreßwerkzeuges wird nachstehend unter Bezugnahme auf die beigefügte Zeichnung näher beschrieben.

Es zeigen:
- Figur 1: ein Einpreßwerkzeug gemäß der Erfindung im Querschnitt in der Offenstellung,
- Figur 2: das Einpreßwerkzeug nach Figur 1 in der Schließstellung,

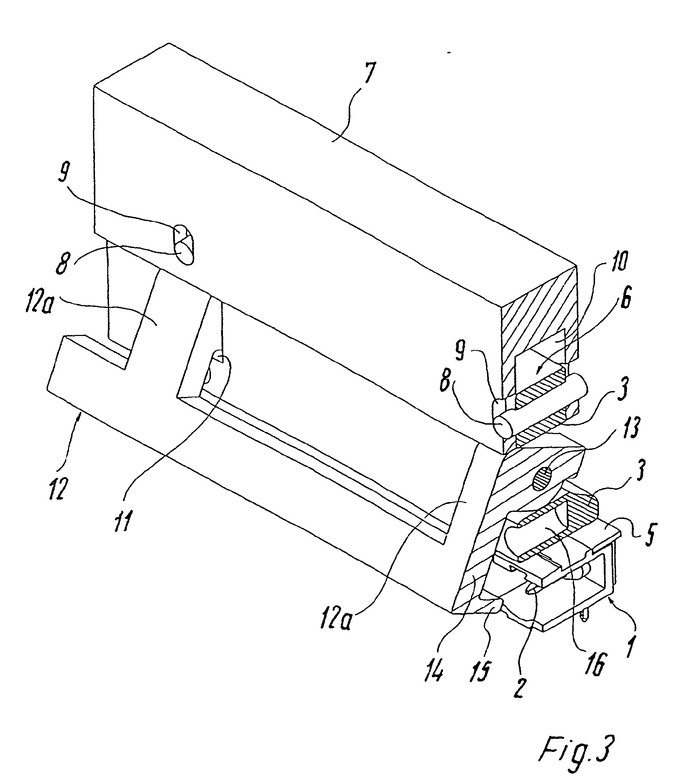

- Figur 3: eine perspektivische, gebrochene Seitenansicht des Einpreßwerkzeuges.

Das Einpreßwerkzeug zum Einpressen elektrischer Anschlußbauteile in Leiterplatten, beispielsweise von Stiftleisten 1 mit um 90° abgewinkelten Stiften 2 ist mehrteilig ausgebildet und beinhaltet ein Druckteil 3, das unterseitig eine Druckfläche 4 hat, die oberseitig auf das Isolierstoffgehäuse 5 der Stiftleiste 1 aufgesetzt werden kann.

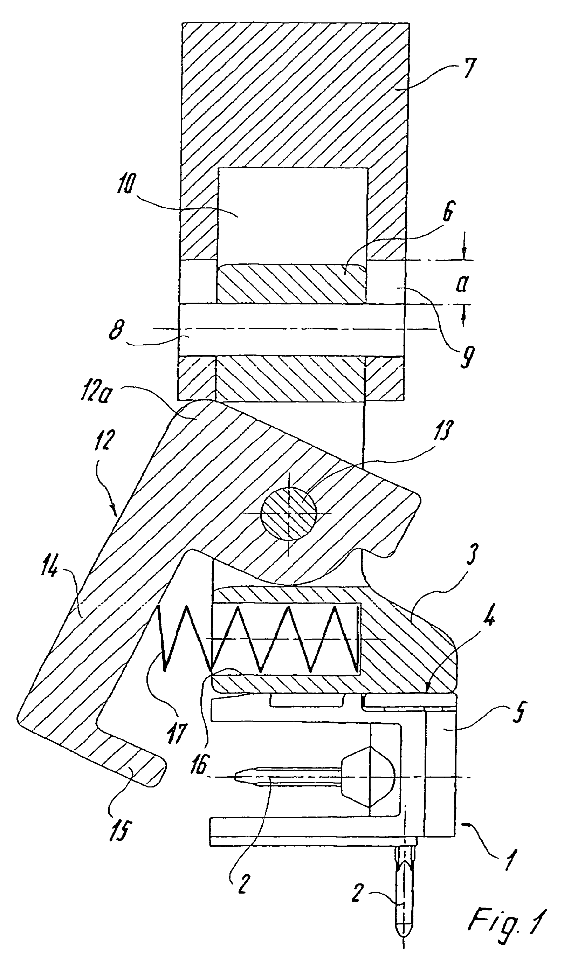

Auf dem oberen, im wesentlichen im Querschnitt rechteckig ausgebildeten Ende 6 des Druckteiles 3 ist heb- und senkbar ein Hubteil 7 verschieblich geführt, das ein Bewegungsspiel a im Verhältnis zum Druckteil 3 aufweist. Im dargestellten Ausführungsbeispiel ist hierzu in dem oberen Ende 6 des Druckteiles 3 ein beidseitig vorstehender Bolzen 8 angeordnet, der in länglichen senkrechten Führungsschlitzen 9 im Hubteil 7 geführt ist. Wenn, beispielsweise in der in Figur 1 gezeigten Offenstellung des Werkzeuges, der Bolzen 8 an einem Ende der Führungsschlitze 9 liegt, definiert der Abstand der freien Bolzenoberfläche zum anderen Ende der Führungsschlitze 9 das Bewegungsspiel a. In dem Hubteil 7 ist ferner ein nach unten offener Aufnahmeraum 10 gebildet, in den das obere Ende 6 des Druckteiles 3 bei der Bewegung des Hubteiles 7 auf das Druckteil zu eintreten kann.

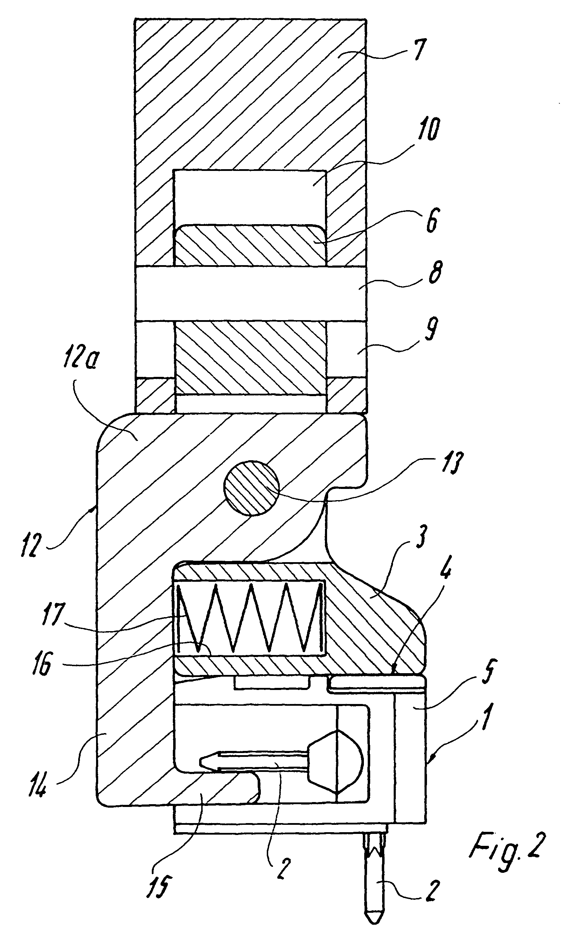

In Aussparungen 11 des Druckteiles 3 ist ferner ein Abstützteil 12 mit zwei voneinander abständigen Bügeln 12a auf einer Achse 13 drehbar gelagert. Das Abstützteil 12 weist am unteren Ende eines nach unten vorstehenden Schenkels 14 ein Abstützelement 15 auf. Das Abstützteil 12 ist nun mit einem Bügel 12a so in der Wegbahn des Druckteiles 3 angeordnet, daß es bei der Bewegung des Hubteiles 7 auf das Druckteil 3 zu in der Phase der Überwindung des Bewegungsspieles a aus der in Figur 1 gezeigten Offenstellung in die in Figur 2 gezeigte Schließstellung verschwenkt wird, in welch letzterer das Abstützelement 15 die im Gehäuse 5 der Stiftleiste 1 befindlichen Enden der 90°-Stifte 2 abstützend untergreift. Das Bewegungsspiel und die Anordnung sind dabei so ausgelegt, daß gewährleistet ist, daß die Abstützung vollzogen ist, bevor das Hubteil 7 das Druckteil 3 im Sinne der Übertragung der Einpreßkräfte auf das Druckteil 3 gewährleistet ist. Danach überträgt dann das Druckteil 3 mittels der Druckfläche 4 die Einpreßkräfte auf die Stiftleiste und deren Stifte.

Im dargestellten Ausführungsbeispiel ist die Anordnung so getroffen, daß in der in Figur 1 gezeigten Offenstellung das Abstützteil 12 so verschwenkt liegt, daß das eine obere Ende der Bügel 12a unmittelbar in der Wegbahn des Hubteiles 7 liegt.

Im Sinne einer Bewegungskopplung dergestalt, daß beim Wiederhochfahren des Hubteiles 7 das Abstützteil 12 mit dem Abstützelement 15 wieder aus der Stiftleiste 1 herausschwenkt, ist im dargestellten Ausführungsbeispiel in einer Ausnehmung 16 im Druckteil 3 eine Feder 17 angeordnet, deren anderes Ende sich an der Innenseite des Schenkels 14 des Abstützteiles 3 abstützt und deren Federkraft darauf gerichtet ist, das Abstützteil 12 in der ausgeschwenkten Offenstellung zu halten. Die Kraft der Feder 17 wird vom Hubteil 1 bei seiner Abwärtsbewegung und der damit verbundenen Einschwenkung des Abstützteiles 12 überwunden.

Ein derartiges Einpreßwerkzeug wird überall dort mit den genannten Vorteilen eingesetzt, wo elektrische Anschlußbauteile einzupressen sind, bei denen die Einpreßkräfte nicht zentrisch auf den Einpreßstift übertragen werden können. Gegebenenfalls ist in Anpassung an derartige Einpreßbauteile dann das Abstützteil mit anders geformten oder anders angeordneten Abstützelementen zu versehen.

Es ist ferner in Abwandlung der vorstehend beschriebenen Ausführungsformen auch grundsätzlich möglich, eine andere Art der Bewegungskopplung zwischen dem Abstützteil und dem Hubteil zu verwirklichen, etwa dergestalt, daß über bewegungskoppelnde Schwenkflächen oder dergleichen das Abstützteil während der Abwärtsbewegung des Hubteiles in einer linearen Einschubbewegung in das elektrische Anschlußbauteil eingefahren wird.

## Patentansprüche

1. Einpreßwerkzeug, zum Einpressen von elektrischen Anschlußbauteilen in Leiterplatten, wobei das Einpreßwerkzeug mehrteilig ausgebildet ist **dadurch gekennzeichnet, daß** es ein auf das Gehäuse (5) des Anschlußbauteiles (1) aufsetzbares Druckteil (3) sowie ein Hubteil (7) aufweist, das ein Bewegungsspiel (a) zum Druckteil (3) bis zu dessen Druckbeaufschlagung hat und ferner ein verlagerbares Abstützteil (12, 12a) vorgesehen ist, das so in der Wegbahn des Hubteiles (7) angeordnet ist, daß es nach Überwindung des Bewegungsspieles des Hubteiles (7) zum Druckteil (3) von diesem in das Anschlußbauteil (1) mit Abstützelementen (15) hineinbewegt ist.

2. Einpreßwerkzeug nach Anspruch 1, **dadurch gekennzeichnet, daß** für die Rückführung des Abstützteiles (12, 12a) in die Offenstellung eine das Abstützteil (12, 12a) beaufschlagende Feder (17) vorgesehen ist.

3. Einpreßwerkzeug nach Anspruch 1. **dadurch gekennzeichnet, daß** das Abstützteil (12, 12a) drehbar in dem Druckteil (3) gelagert ist.

4. Einpreßwerkzeug nach Anspruch 1, **dadurch gekennzeichnet, daß** das Hubteil (7) auf dem oberen Ende (6) des Druckteiles (3) verschieblich geführt ist und das Abstützteil (12, 12a) in einer Aussparung (11) des Druckteiles (3) unterhalb des Hubteiles (7) gelagert ist.

5. Einpreßwerkzeug nach den Ansprüchen 2 und 4, **dadurch gekennzeichnet, daß** das Abstützteil (12, 12a) durch die Feder (17) so in die Offenstellung gedrückt ist, daß ein oberes Ende des Abstützteiles (12, 12a) unmittelbar in der Wegbahn des Hubteiles (7) liegt.

6. Einpreßwerkzeug nach Anspruch 1 und 4, **dadurch gekennzeichnet, daß** das Hubteil (7) auf dem oberen Ende (6) des Druckteiles (3) dieses übergreifend angeordnet ist und in dem Druckteil (3) beidseitig aus diesem vorstehende Bolzen (8) angeordnet sind, die in Führungsschlitze (9) im übergreifenden Bereich des Hubteiles (7) eingreifen, wobei der Abstand zwischen dem freien Bereich der Bolzen (8) in der Offenstellungsendlage der Teile zum gegenüberliegenden anderen Ende der Führungsschlitze (9) das Bewegungsspiel (a) definiert.

7. Einpreßwerkzeug nach Anspruch 1, **dadurch gekennzeichnet, daß** das Abstützteil (12, 12a) an einem nach unten weisenden Schenkel (14) ein oder mehrere Abstützelemente (15) auf der dem elektrischen Anschlußbauteil (1) zugewandten Seite aufweist.

8. Einpreßwerkzeug nach Anspruch 2, **dadurch gekennzeichnet, daß** die Feder (17) in einer Ausnehmung (16) des Druckteiles (3) angeordnet ist und sich mit ihrem anderen Ende auf einer zugewandten Fläche des Abstützteiles (12, 12a) abstützt.

## Claims

1. Press-fitting tool for press-fitting electric connecting components into printed circuit boards, the press-fitting tool being designed in several parts, **characterised in that** it comprises a pressure part (3) for placement on the housing (5) of the connecting component (1) and a lifting part (7) with a clearance (a) relative to the pressure part (3) up to its pressurisation, and **in that** a displaceable support part (12, 12a) is provided, which is so arranged in the path of the lifting part (7) that, following the overcoming of the clearance between the lifting part (7) and the pressure part (3), it is moved by the latter into the connecting component (1) with support elements (15).

2. Press-fitting tool according to claim 1, **characterised in that** a spring (17) acting on the support part (12, 12a) is provided to return the support part (12, 12a) to its open position.

3. Press-fitting tool according to claim 1, **characterised in that** the support part (12, 12a) is rotatably mounted within the pressure part (3).

4. Press-fitting tool according to claim 1, **characterised in that** the lifting part (7) is displaceably guided on the upper end of the pressure part (3) and the support part (12, 12a) is installed in a recess (11) of the pressure part (3) below the lifting part (7).

5. Press-fitting tool according to claims 2 and 4, **characterised in that** the support part (12, 12a) is pushed into the open position by the spring (17), so that an upper end of the support part (12, 12a) lies directly in the path of the lifting part (7).

6. Press-fitting tool according to claims 1 and 4, **characterised in that** the lifting part (7) is arranged on the upper end (6) of the pressure part (3) to overlap the latter, and **in that** pins (8) project from both sides of the pressure part (3) and engage guide slots (9) in the overlapping area of the lifting part (7), the distance between the free area of the pins (8) in the open position of the parts and the opposite other end of the guide slots (9) defining the clearance (a).

7. Press-fitting tool according to claim 1, **characterised in that** the support part (12, 12a) has one or more support elements (15) on a downward-oriented leg (14) on the side facing the electric connecting component (1).

8. Press-fitting tool according to claim 2, **characterised in that** a spring (17) is located in a recess (16) of the pressure part (3), its other end being supported on an adjacent surface of the support part (12, 12a).

## Revendications

1. Outil d'insertion, pour l'insertion d'éléments de contact électriques dans des plaquettes de circuits imprimés, cet outil d'insertion étant formé de plusieurs pièces, **caractérisé en ce qu'**il comporte une pièce de pression (3) rapportable sur le boîtier (5) de l'élément de contact (1) ainsi qu'une pièce de course (7) présentant un jeu de déplacement (a) vers la pièce de pression (3) jusqu'à la compression de celle-ci, et **en ce qu'**une pièce d'appui (12, 12a) décalable est en outre prévue, laquelle est disposée sur la trajectoire de la pièce de course (7) de manière à être insérée par celle-ci dans l'élément de contact (1) avec des éléments d'appui (15), une fois parcouru le jeu de déplacement de la pièce de course (7) vers la pièce de pression (3).

2. Outil d'insertion selon la revendication 1, **caractérisé en ce qu'**un ressort (17) appliqué contre la pièce d'appui (12, 12a) est prévu pour le retour de la pièce d'appui (12, 12a) en position d'ouverture.

3. Outil d'insertion selon la revendication 1, **caractérisé en ce que** la pièce d'appui (12, 12a) est montée rotative dans la pièce de pression (3).

4. Outil d'insertion selon la revendication 1, **caractérisé en ce que** la pièce de course (7) est guidée en translation sur l'extrémité supérieure (6) de la pièce de pression (3), et **en ce que** la pièce d'appui (12, 12a) est logée dans un évidement (11) de la pièce de pression (3) sous la pièce de course (7).

5. Outil d'insertion selon les revendications 2 et 4, **caractérisé en ce que** la pièce d'appui (12, 12a) est repoussée vers la position d'ouverture par le ressort (17) de manière à ce qu'une extrémité supérieure de la pièce d'appui (12, 12a) soit directement située sur la trajectoire de la pièce de course (7).

6. Outil d'insertion selon les revendications 1 et 4, **caractérisé en ce que** la pièce de course (7) est disposée sur l'extrémité supérieure (6) de la pièce de pression (3) en enveloppant celle-ci, et **en ce que** des axes (8) sont disposés dans la pièce de pression (3), en faisant saillie des deux côtés de celle-ci, lesquels s'engagent dans des fentes de guidage (9) dans la partie enveloppante de la pièce de course (7), l'espacement entre la partie libre des axes (8) en position finale d'ouverture des pièces et l'autre extrémité opposée des fentes de guidage (9) définissant le jeu de déplacement (a).

7. Outil d'insertion selon la revendication 1, **caractérisé en ce que** la pièce d'appui (12, 12a) présente sur une branche (14) dirigée vers le bas un ou plusieurs éléments d'appui (15) du côté dirigé vers l'élément de contact électrique (1).

8. Outil d'insertion selon la revendication 2, **caractérisé en ce** le ressort (17) est disposé dans un évidement (16) de la pièce de pression (3) et s'appuie par son autre extrémité contre une surface opposée de la pièce d'appui (12, 12a).
